# EUROPEAN PATENT APPLICATION

(11) **EP 4 746 674 A1**
(43) Date of publication of application: **20.05.2026**
(21) Application number: 25211593.6
(22) Date of filing: 28.10.2025
(51) Int. Cl.: H10W 20/41, H10D 89/10

(54) **INTEGRATED CIRCUIT DEVICES**

(30) Priority: 13.11.2024 US 202463719695 P; 13.05.2025 US 202519206492
(71) Applicant: Samsung Electronics Co., Ltd., Suwon-si, Gyeonggi-do 16677 (KR)
(72) Inventor: LIM, Jinyoung, San Jose, CA 95134 (US); PARK, YoungGook, San Jose, CA 95134 (US); SHIN, Hyo Jong, San Jose, CA 95134 (US); SEO, Kang-ill, San Jose, CA 95134 (US)
(74) Representative: Kuhnen & Wacker Patent- und Rechtsanwaltsbüro PartG mbB

(57) **Abstract**

A circuit device may include a first cell that includes a first cell structure on an upper surface of a substrate, a second cell that includes a second cell structure on the upper surface of the substrate, signal tracks on the upper surface of the substrate, a first power delivery track on a lower surface of the substrate, and a power delivery region that is bounded by the first cell at a first boundary and is bounded by the second cell at a second boundary, where the second boundary is opposite to the first boundary with respect to the power delivery region in a second direction that intersects the first direction, where the power delivery region includes a first power delivery contact, and where the first power delivery track is electrically connected to the first cell structure and the second cell structure through the first power delivery contact.

## Description

### FIELD

The present disclosure relates to circuit devices.

### BACKGROUND

Integrated circuit (IC) devices, chips, and/or blocks may receive power and data signals from one or more external sources (e.g., a power source and a data source). Some IC devices may receive power and data signals via frontside conductive structures, which may provide power distribution networks (PDNs). For example, an IC device may include a frontside power distribution network (FSPDN) having one or more components that are formed during back-end-of-line (BEOL) processes, and conductive structures for data signals may be on the same side of an IC device as the FSPDN. IC devices may include various transistor structures, including, for example, two-dimensional (2D) planar structures, fin field-effect transistors (FinFETs), gate-all-around transistors, multi-bridge channel FETs (MBCFETs^{™}), and stacked transistors (e.g., three-dimensional (3D) stacked transistors).

More recently, backside PDNs (BSPDNs), in which a backside of an IC device is used as a PDN, have also been developed. In a BSPDN structure, a power rail may be formed on the backside of a semiconductor chip, IC device, or wafer (generally referred to herein as a semiconductor device), rather than on the frontside thereof. As such, the power rail may be on a side of the semiconductor structure (e.g., a side of a substrate of the IC device) that is opposite from the active components (e.g., transistors) of the IC device. Moreover, conductive structures for data signals may be on the frontside of the semiconductor device, and thus the BSPDN and the conductive structures for the data signals may be on opposite sides of the semiconductor device.

### SUMMARY

A circuit device may include a substrate, a first cell that includes a first cell structure on an upper surface of the substrate, a second cell that includes a second cell structure on the upper surface of the substrate, signal tracks on the upper surface of the substrate, where the signal tracks are electrically connected to the first cell structure and/or the second cell structure, a first power delivery track on a lower surface of the substrate, where the lower surface of the substrate is opposite to the upper surface of the substrate in a first direction, and a power delivery region that is bounded by the first cell at a first boundary and is bounded by the second cell at a second boundary, where the second boundary is opposite to the first boundary with respect to the power delivery region in a second direction that intersects the first direction, where the power delivery region includes a first power delivery contact, and where the first power delivery track is electrically connected to the first cell structure and the second cell structure through the first power delivery contact.

In some embodiments, the first power delivery contact is between the first boundary and the second boundary in the second direction.

In some embodiments, the circuit device further includes active patterns on the substrate and diffusion break patterns that extend into the substrate, where the first cell structure includes a first active pattern of the active patterns at the first boundary.

In some embodiments, the first cell is free of the diffusion break patterns at the first boundary.

In some embodiments, the first cell includes a third boundary that is opposite to the first boundary with respect to the first cell in the second direction, and where the first cell structure further includes a second active pattern of the active patterns or a first diffusion break pattern of the diffusion break patterns at the third boundary.

In some embodiments, the second cell structure includes a third active pattern of the active patterns at the second boundary.

In some embodiments, the second cell structure is free of the diffusion break patterns at the second boundary.

In some embodiments, the second cell includes a fourth boundary that is opposite to the second boundary with respect to the second cell in the second direction, and where the second cell structure further includes a fourth active pattern of the active patterns or a second diffusion break pattern of the diffusion break patterns at the fourth boundary.

In some embodiments, a first signal track of the signal tracks has a first length in the second direction, and a second signal track of the signal tracks has a second length that is less than the first length in the second direction.

In some embodiments, the second signal track is free of overlap with the first power delivery contact in the first direction.

In some embodiments, the first signal track at least partially overlaps the first power delivery contact in the first direction.

In some embodiments, the power delivery region includes a second power delivery contact.

In some embodiments, the circuit device further includes a second power delivery track that is electrically connected to the first cell structure and the second cell structure through the second power delivery contact.

In some embodiments, the first power delivery track is configured to supply a first voltage, and where the second power delivery track is configured to supply a second voltage that is different from the first voltage.

A circuit device may include a substrate that includes diffusion break patterns, a first cell that includes a first cell structure on an upper surface of the substrate, a second cell that includes a second cell structure on the upper surface of the substrate, signal tracks on the upper surface of the substrate, where the signal tracks are electrically connected to the first cell structure and/or the second cell structure, a first power delivery track on a lower surface of the substrate, where the lower surface of the substrate is opposite to the upper surface of the substrate in a first direction, and a power delivery region that is bounded by the first cell at a first boundary and is bounded by the second cell at a second boundary, where the second boundary is opposite to the first boundary with respect to the power delivery region in a second direction that intersects the first direction, where the power delivery region includes a first power delivery contact and at least one active pattern, where the first power delivery track is electrically connected to the first cell structure and the second cell structure through the first power delivery contact, and where the power delivery region is free of the diffusion break patterns.

In some embodiments, the first cell structure includes a first active pattern of the at least one active patterns at the first boundary, and where the second cell structure includes a second active pattern of the at least one active patterns at the second boundary.

In some embodiments, the first cell includes a third boundary that is opposite to the first boundary with respect to the first cell in the first direction, and where the first cell structure further includes a first diffusion break pattern of the diffusion break patterns at the third boundary.

In some embodiments, the second cell includes a fourth boundary that is opposite to the second boundary with respect to the second cell in the second direction, and where the second cell structure includes a second diffusion break pattern of the diffusion break patterns at the fourth boundary.

In some embodiments, the circuit device further includes a second power delivery track that is electrically connected to the first cell structure and the second cell structure through a second power delivery contact of the power delivery region.

A circuit device may include a substrate that includes diffusion break patterns, a first cell that includes a first cell structure on an upper surface of the substrate, a second cell that includes a second cell structure on the upper surface of the substrate, where the second cell structure is spaced apart from the first cell structure in a first direction, signal tracks on the upper surface of the substrate, where the signal tracks are electrically connected to the first cell structure and/or the second cell structure, a power delivery track on a lower surface of the substrate, where the lower surface of the substrate is opposite to the upper surface of the substrate in a second direction that intersects the first direction, and a power delivery region that is bounded by the first cell at a first boundary and is bounded by the second cell at a second boundary, where the second boundary is opposite to the first boundary with respect to the power delivery region in the first direction, where the power delivery region includes a power delivery contact and at least one active pattern and is free of diffusion break patterns, where the power delivery track is electrically connected to the first cell structure and the second cell structure through the power delivery contact, where the first cell structure includes a first active pattern of the at least one active pattern at the first boundary, where the second cell structure includes a second active pattern of the at least one active pattern at the second boundary, where the first cell includes a third boundary that is opposite to the first boundary with respect to the first cell in the first direction, and where the first cell structure further includes a first diffusion break pattern of the diffusion break patterns at the third boundary.

Other devices, apparatus, and/or methods according to some embodiments will become apparent to one with skill in the art upon review of the following drawings and detailed description. It is intended that all such additional embodiments, in addition to any and all combinations of the above embodiments, be included within this description, be within the scope of the present disclosure, and be protected by the accompanying claims.

### BRIEF DESCRIPTION OF THE DRAWINGS

FIG. 1A is a schematic view illustrating an example integrated circuit device including a cell array according to a comparative embodiment.
FIG. 1B is a schematic plan view illustrating example cells of the cell array of FIG. 1A according to a comparative embodiment.
FIG. 1C is a schematic plan view illustrating the cells of FIG. 1B that are joined together according to a comparative embodiment.
FIG. 1D is a circuit diagram corresponding to the example cells of FIG. 1C.
FIG. 1E is a schematic cross-sectional view of a first surface of the cells of FIG. 1B.
FIG. 2A is a schematic plan view illustrating an example integrated circuit device according to some embodiments of the present disclosure.
FIGS. 2B and 2C are schematic cross-sectional views illustrating the configurations of example integrated circuit device of FIG. 2A.
FIG. 3A is a schematic plan view illustrating an example integrated circuit device according to some embodiments of the present disclosure.
FIG. 3B is a circuit diagram corresponding to the example integrated circuit device of FIG. 3A.
FIGS. 4A, 4B, 4C, 4D, 4E, 4F, 4G, and 4H are schematic plan views illustrating methods of fabricating integrated circuit devices according to some embodiments of the present disclosure.

### DETAILED DESCRIPTION OF EMBODIMENTS

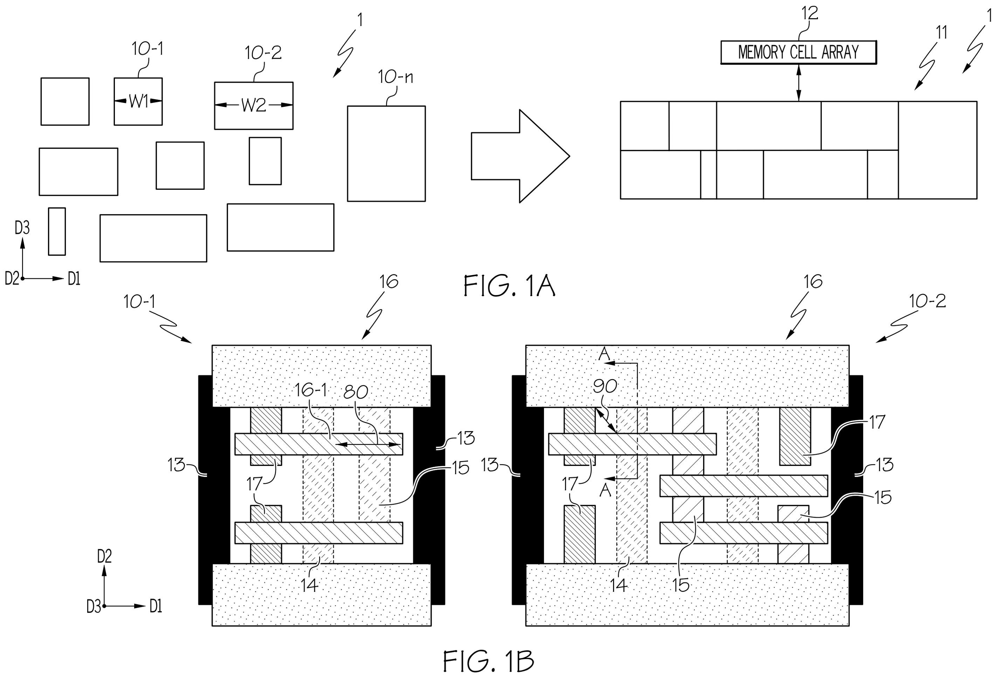

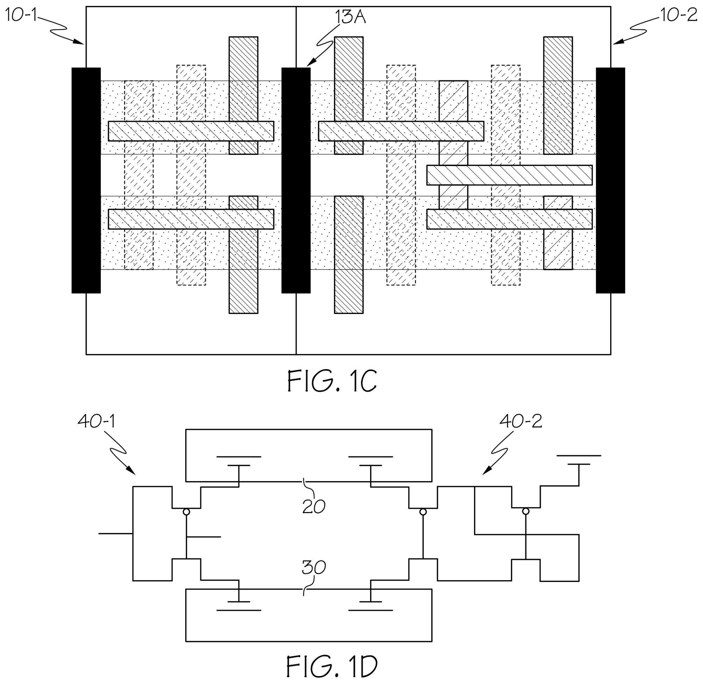

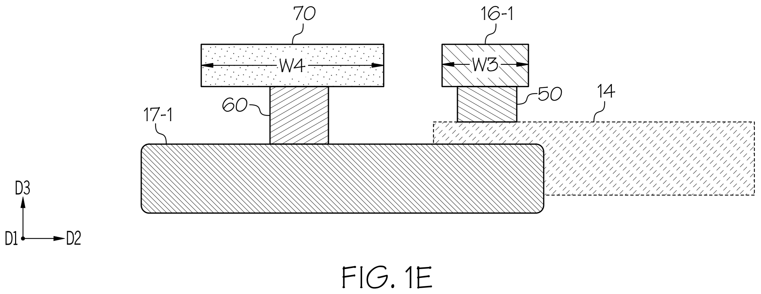

FIG. 1A is a schematic plan view illustrating an example integrated circuit device 1 including a cell array 11 (e.g., a cell array) according to a comparative embodiment. FIG. 1B is a schematic plan view illustrating example cells 10-1, 10-2 of the cell array 11 of FIG. 1A according to a comparative embodiment. FIG. 1C is a schematic plan view illustrating the cells 10-1, 10-2 of FIG. 1B being joined together according to a comparative embodiment. FIG. 1D is a circuit diagram corresponding to the example joined cells of FIG. 1C. FIG. 1E is a schematic cross-sectional view of a first surface of the cell 10-1 along line A-A of FIG. 1B.

In a comparative embodiment illustrated by FIGS. 1A-1B, an integrated circuit device 1 includes a plurality of cells 10-1, 10-2, ... 10-n (collectively referred to hereinafter as cells 10) that are joined to each other to define a cell array 11 that is electrically connected to, for example, a memory cell array 12. As used herein, "cell" or "standard cell" refers to a cell having one or more predefined dimensions (e.g., lengths of the cell, widths of the cell, an area of the cell, and/or an active region dimension), one or more predefined cell structures (e.g., 2D planar structures, FinFETs, gate-all-around transistors, (MBCFETs^{™}), and/or 3D stacked transistors, among other known cell structures), and one or more predefined operations (e.g., read operations, write operations, decoding operations, sense amplifier control operations, input/output logic operations, clock operations, power gating operations, and/or well tapping operations, among other known operations). As an example, first and second cells 10-1, 10-2 may respectively have widths W1, W2 in the first direction D1 that are different from each other, perform different operations, and/or have different cell structures.

In some embodiments, each of the cells 10 may include diffusion break patterns 13, an active gate pattern 14, source/drain patterns 15, front-side signal tracks 16, power delivery contacts 17, a middle-of-line (MOL) structure (not shown), and a FSPDN (not shown).

The diffusion break patterns 13 may be provided on boundaries of the cells 10 to thereby electrically insulate active regions between adjacent cells 10. Example diffusion break patterns 13 include, but are not limited to, a single diffusion break (SDB) region or a double diffusion break (DDB) region. In some embodiments, the diffusion break patterns 13 may (or may not) include a shallow trench isolation (STI) region therein, and the diffusion break patterns 13 may each include one or more dummy gate patterns (e.g., a nonfunctioning gate pattern that enhances process uniformity and inhibit mismatches).

The active gate pattern 14 of the first cell 10-1 may be electrically connected to a logic input or output power supply (not shown) by a first front-side signal track 16-1 and the MOL structure. The source/drain patterns 15 may be electrically connected to power supply lines (not shown) by the power delivery contacts 17, the front-side signal tracks 16, and the MOL structure. The active gate pattern 14 and source/drain patterns 15 may include various types of known electrically conductive materials, such as doped polycrystalline silicon (Poly-Si), titanium nitride (TiN), tantalum nitride (TaN), molybdenum (Mo), cobalt, (Co), nickel silicide (NiSi), and/or other known electrically conductive materials. The power delivery contacts 17 may include known electrically conductive materials and connect the source/drain patterns 15 to drain (VDD) and source (VSS) voltages generated by an external source.

The MOL structure (not shown) may include interlayer insulating layer(s) in which conductive wire(s) (e.g., metal wire(s)) and conductive via plug(s) (e.g., metal via plug(s)) are provided. The FSPDN may be spaced apart from the front-side signal tracks 16 in the first horizontal direction D1 and may be adjacent to at least one of the diffusion break patterns 13. In some embodiments, the FSPDN may be shared by the cells 10-1, 10-2 and may be electrically connected to one or more cell structures of the cells 10-1, 10-2, as described below in further detail. In some embodiments, the FPSDN may include a conductive material, such as a metal and may be configured to provide a power delivery path for the integrated circuit device 1.

As shown in FIGS. 1C-1D, when the first cell 10-1 and the second cell 10-2 are joined (e.g., directly bonded or joined with a filler cell or spacing cell therebetween) to each other to form the cell array 11 (or a portion thereof), the first and second cells 10-1, 10-2 may be electrically connected and joined to each other to thereby reduce the number of power sources. As an example and as indicated by boxes 20, 30 of FIG. 1D, which includes a circuit diagram 40-1 corresponding to the first cell 10-1 and a circuit diagram 40-2 corresponding to the second cell 10-2, the number of power sources may be reduced from four to two when the first and second cells 10-1, 10-2 are joined. Furthermore, a set of the diffusion break patterns 13A of the first and second cells 10-1, 10-2 that are on the boundary therebetween may be joined and/or connected to each other using known SDB/DDB joining processes.

Some embodiments of the present disclosure may arise from the realization that joining the first and second cells 10-1, 10-2 may inhibit the electrical, operational, and performance characteristics of the cell array 11. As an example, and with reference to FIG. 1E, a gate contact layer 50 of a MOL structure may electrically connect the active gate pattern 14 and the first front-side signal track 16-1, and a power delivery contact via 60 of the MOL structure 18 may electrically connect a FSPDN 70 to a first power delivery contact 17-1. The first front-side signal track 16-1 may have a width W3 that is less than a width W4 of the FSPDN 70 in the second direction D2. During a fabrication process, it may be difficult to implement a cut layer (e.g., a negative mask) on the first front-side signal track 16-1. That is, it may be difficult to implement a mask layer in which vias are electrically connected to the first front-side signal track 16-1 and other portions of the cell 10 due to the relatively larger width W4 of the FSPDN 70. As such, it may be difficult to inhibit or prevent electrical shorts and/or manufacturing defects without implementing a marginal length extension (e.g., a minimum additional length or extension added to the signal tracks 16 to provide sufficient distances between other elements) between the first front-side signal track 16-1 and the gate contact layer 50, as indicated by double-sided arrow 80 in FIG. 1B. In some embodiments, larger marginal length extensions may increase the overall area and/or layout complexity of the cell 10 and result in higher power consumption, thereby inhibiting electrical, operational, and performance characteristics of the cells 10.

Furthermore, a spacing margin (as indicated by double sided arrow 90 in FIG. 1B) between the power delivery contact via 60 and the gate contact layer 50 may be limited due to the overlap therebetween in the second direction D2, thereby inhibiting electrical, operational, and performance characteristics of the cells 10. As an example, the limited spacing margins may induce process manufacturing variations, yield loss, short nets, and/or parasitic capacitances, which may inhibit electrical, operational, and performance characteristics of the cells 10.

Embodiments of the present disclosure provide integrated circuit devices having cells that are connected to a BSPDN and shared power contacts to enhance the electrical, operational, and performance characteristics of the cell array. As an example, the BSPDN and shared power contacts may simplify the design and implementation of the cut layer for the first front-side signal track during the fabrication process due to the wider PDN tracks being incorporated as part of the BSPDN. Moreover, the marginal length extension can be reduced due to the reduced complexity of implementing the cut layer during the fabrication process, thereby reducing the overall area, layout complexity, and power consumption of the cells. As another example, the BSPDN and shared power contacts may increase the spacing margin between the power delivery contact and the gate contact layer due to these components being provided on different layers (e.g., the power delivery contact and the gate contact layer may be free of overlap in the second direction D2).

Embodiments of the present disclosure also provide integrated circuit devices having cells with selectively positioned and/or omitted diffusion break patterns to enhance the electrical, operational, and performance characteristics of the cell array. According to example embodiments of the present disclosure, the diffusion break pattern at some boundaries of the cell may be removed or omitted, and a power delivery region, which includes the shared power contacts, may be merged or joined with a BSPDN structure, which may result in a more compact layout/reduced area for the integrated circuit device.

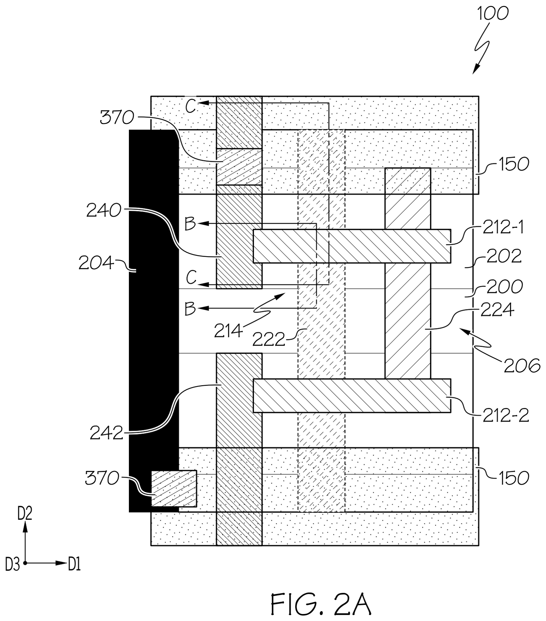

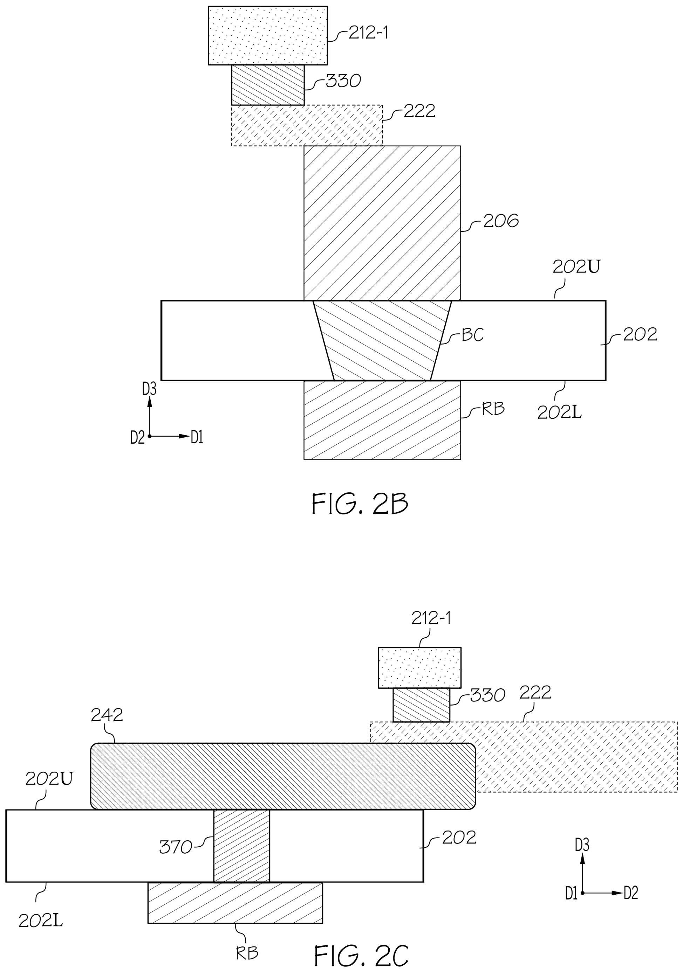

Referring to FIGS. 2A-2C, an integrated circuit device 100 according to some embodiments of the present disclosure is shown. FIG. 2A is an example plan view relative to the backside or lower surface of the integrated circuit device 100. FIG. 2B is an example cross-sectional view of the integrated circuit device 100 along dashed line B-B in FIG. 2A, and FIG. 2C is an example cross-sectional view of the integrated circuit device 100 along dashed line C-C in FIG. 2A.

In some embodiments, the integrated circuit device 100 may include a BSPDN 150 on a lower (or backside) surface 202L of a substrate 202. The integrated circuit device 100 may also include a first cell 200, power delivery contacts 240, 242 and front-side signal tracks 212 that are on an upper surface 202U of the substrate 202. While one cell 200 is shown, it should be understood that the integrated circuit device 100 may have any number of cells in other embodiments. In some embodiments, the first cell 200 may include a diffusion break pattern 204, a cell structure 206, a MOL structure 214, an active gate pattern 222, and a source/drain pattern 224. While one source/drain pattern 224 is shown in FIG. 2A, it should be understood that additional source/drain patterns 224 may be included in other embodiments.

The substrate 202 may include a semiconductor material, such as a group IV semiconductor, a group III-V compound semiconductor, or a group II-VI compound semiconductor. For example, the group IV semiconductor may include silicon, germanium, or silicon-germanium. The substrate 202 may be provided as a bulk wafer, an epitaxial layer, a silicon on insulator (SOI) layer, a semiconductor on insulator (SeOI) layer, or the like.

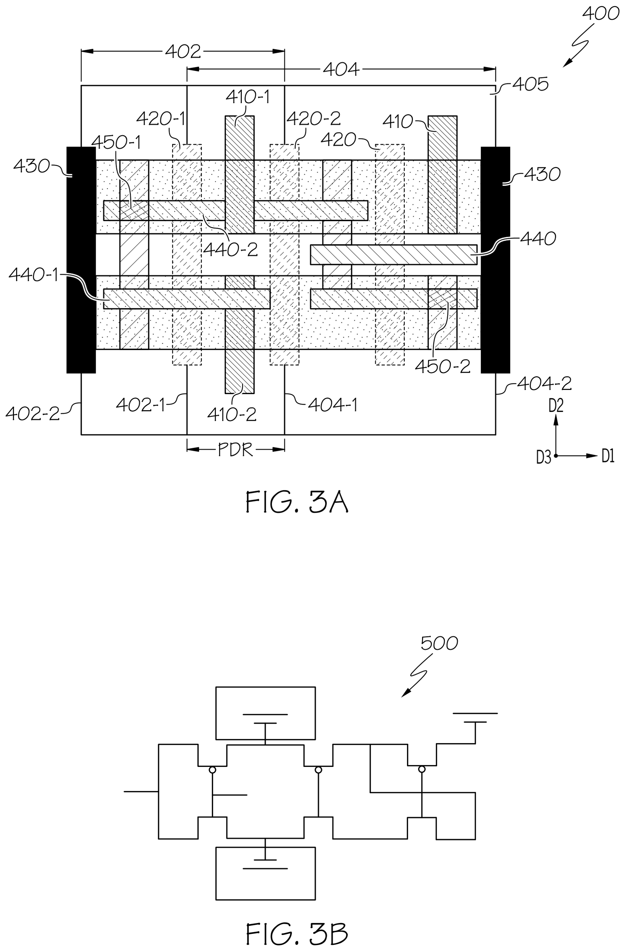

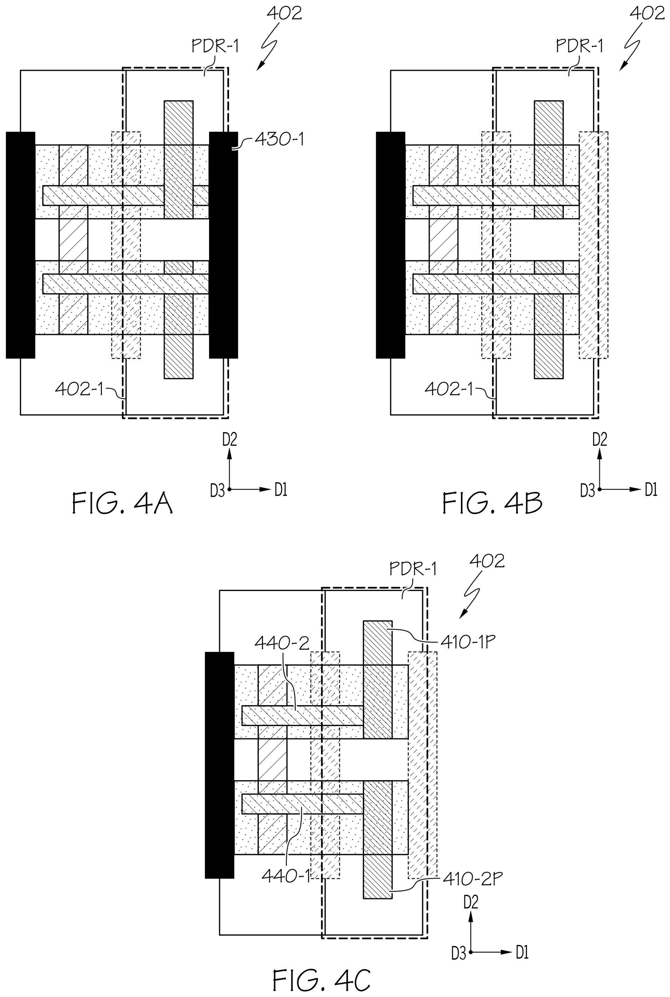

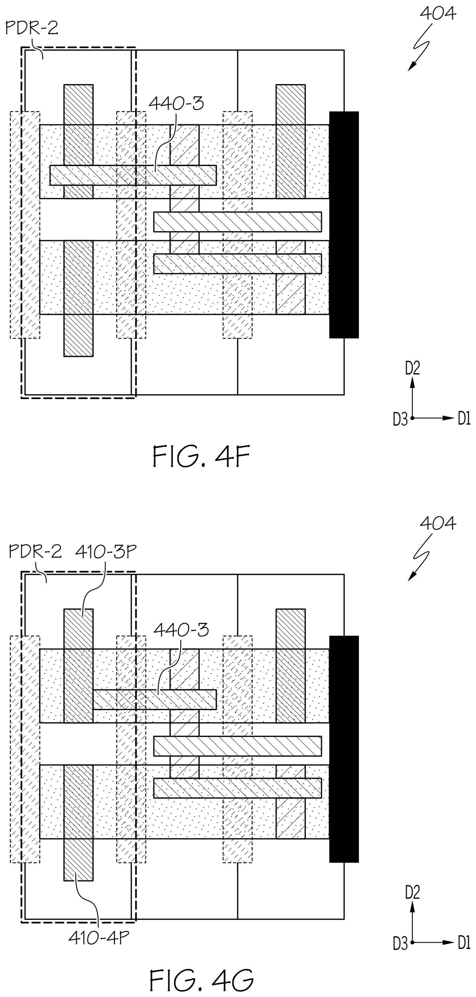

The diffusion break pattern 204 may be selectively positioned on the substrate 202 (e.g., one or more boundaries of the cell 200), as described below in further detail with reference to FIGS. 3A-3B and 4A-4H. In some embodiments, the diffusion break pattern 204 may include one or more dummy gate patterns and an insulation material including, but not limited to, a single diffusion break (SDB) region, a double diffusion break (DDB) region, and/or a shallow trench isolation (STI) region.

In some embodiments, and referring to FIG. 2B, the cell structure 206 may have a stacked transistor structure including first and second transistors that are vertically stacked on the substrate 202. The first transistor may be a first type of transistor (e.g., a n-type metal-oxide-semiconductor (NMOS) transistor) and the second transistor may be a second type of transistor (e.g., a p-type metal-oxide-semiconductor (PMOS) transistor). The first and second types of transistors may be complementary to each other (e.g., CMOS transistors), and in some embodiments the cell structure 206 may be or may include a stack of CMOS transistors. The first and second transistors may be stacked in any order, resulting in a stack comprising a top device (also referred to herein as an upper device or second transistor, relative to an underlying substrate) and a bottom device (also referred to herein as a lower device or first transistor, relative to the underlying substrate). Gates, channels, and source/drain regions of the upper and lower devices may likewise be referred to by the terms "upper" and "lower" (e.g., upper/lower gates, upper/lower channels, upper/lower source/drain regions, and upper/lower inner spacers). While a 3DSFET is described herein, it should be understood that the cell structure 206 is not limited to the embodiments illustrated and described herein and may include, for example, a planar transistor, a gate-all-around field-effect transistor (GAAFET), a recessed channel array transistor (RCAT), a fin field-effect transistor (FinFET), a multi-bridge-channel field effect transistor (MBCFET^{™}), and/or any other type of transistor structure.

In some embodiments, the MOL structure 214 may include interlayer insulating layer(s) in which conductive wire(s) (e.g., metal wire(s)) and conductive via plug(s) (e.g., metal via plug(s)) are provided. Various elements of the cell structure 206 may be (electrically) connected to one of the conductive wires of the MOL structure 214. In some embodiments, the front-side signal tracks 212 and the BSPDN 150 may be electrically connected to the cell structure 206 through the MOL structure 214. As an example, the MOL structure 214 may include front-side vias VA, a front-side middle layer CM, an upper-epi contact CA, front-side and back-side contacts TB, a BSPDN contact RV, a lower-epi contact CR, a gate contact layer 330 (shown in FIG. 2C), and a power delivery contact via 370 (shown in FIG. 2C). However, the MOL structure 214 is not limited to the embodiments described herein.

In some embodiments, the active gate pattern 222 may be electrically connected to a first front-side signal track 212-1 and connected to the cell structure 206 through the gate contact layer 330. The source/drain pattern 224 may be electrically connected to cell structure 206 through the MOL structure 214 (e.g., upper-epi contact CA), the front-side signal tracks 212, and the BSPDN 150. The active gate pattern 222 and the source/drain pattern 224 may include various types of electrically conductive materials, such as doped polycrystalline silicon (Poly-Si), titanium nitride (TiN), tantalum nitride (TaN), molybdenum (Mo), cobalt, (Co), nickel silicide (NiSi), and/or other known electrically conductive materials.

In some embodiments, the power delivery contacts 240, 242 may include known electrically conductive materials and selectively connect various elements of the cell structure 206 (e.g., source/drain regions of the cell structure 206) to the front-side signal tracks 212 and/or the BSPDN 150. In some embodiments, the front-side signal tracks 212 may be on a frontside (or upper surface) of the cell structure 206/substrate 202 and may include elements formed by a back-end-of-line (BEOL) portion of device fabrication. The front-side signal tracks 212 may include conductive elements and insulating elements therebetween (not shown). The front-side signal tracks 212 may be electrically connected to, for example, the cell structure 206 through the MOL structure 214, the BSPDN 150, and one or more cell structures of additional cells (described below in further detail).

In some embodiments, the BSPDN 150 may include a power delivery network that includes one or more power delivery tracks RB that are on or in a backside of the cell 200, are electrically insulated from each other by a backside insulator BILD2, and are configured to receive a drain voltage (VDD) and/or a source voltage (VSS) from an external source. Different ways to connect from the frontside to the backside may include, for example, a power delivery track RB configured as a front via backside power rail (FV-BPR) and a via BC configured as a direct backside contact. The power delivery tracks RB may be electrically connected to the cell structure 206 through the MOL structure 214 and the first front-side signal track 212-1. In some embodiments, an intervening structure (not shown) may be provided between and separate the substrate 202 and the BSPDN 150. The BSPDN 150 may increase a power delivery efficiency in the integrated circuit device 100, reduce an area used for power delivery in the integrated circuit device 100, and/or improve a voltage drop (i.e., IR drop) in the integrated circuit device 100.

As shown in FIG. 2C, the power delivery contact 242 may be electrically connected to one of the power delivery tracks RB of the BSPDN 150 through the power delivery contact via 370 of the MOL structure 214. The first front-side signal track 212-1 may be free of overlap with the power delivery contact 242 in the second direction D2, the power delivery contact via 370, and the BSPDN 150.

Accordingly, the wider power delivery track RB of the BSPDN 150 that is provided on the backside of the cell 200 enables the cut layer that is used to form the first front-side signal track 212-1 during a fabrication process to be implemented with increased simplicity and enhanced efficiency and accuracy. Moreover, the implementation of the cut layer may result in the active gate pattern 222 having a reduced marginal length extension (as described below in further detail) and thus may reduce the overall area, layout complexity, and power consumption of the cell 200. Furthermore, the spacing margin between the power delivery contact via 370 and the gate contact layer 330 may be increased relative to the cell 10 due to the lack of overlap therebetween in the second direction D2. Accordingly, the increased spacing margin may result in reduced process manufacturing variations, yield loss, short nets, and/or parasitic capacitances, of the cell 200.

Referring to FIGS. 3A-3B, schematic plan and circuit diagram views, respectively, of an example integrated circuit device 400 is shown. In some embodiments, the integrated circuit device 400 includes cells 402, 404, which may be similar to the cell 200. In some embodiments, the integrated circuit device 400 further includes a plurality of power delivery contacts 410 (e.g., the power delivery contacts 240, 242), active patterns 420 (e.g., source/drain patterns 224) on a substrate 405, diffusion break patterns 430 (e.g., the diffusion break pattern 204) extending into the substrate 405 in the third direction D3, front-side signal tracks 440, and power delivery tracks 450-1, 450-2 of the BSPDN (e.g., power delivery tracks RB).

In some embodiments, the cells 402, 404 may be joined to (or overlap) each other such that they collectively form a power delivery region PDR that is bounded by a boundary 402-1 of the cell 402 and by a boundary 404-1 of the cell 404. The boundaries 402-1, 404-1 may be opposite to each other with respect to the power delivery region PDR in the first direction D1.

The cell 402 may also include a boundary 402-2 that is opposite to the boundary 402-1 in the first direction D1, and the cell 404 may also include a boundary 404-2 that is opposite to the boundary 404-1 in the first direction D1. In some embodiments, the boundaries 402-1, 404-1 correspond to boundaries in which adjacent cells may be merged, and boundaries 402-2, 404-2 correspond to predetermined boundaries in which adjacent cells are not merged. In some embodiments, ones of the diffusion break patterns 430 or ones of the active patterns 420 may be on the boundaries 402-2, 404-2 of cells 402, 404, respectively.

In some embodiments, the power delivery contacts on each of the individual cells 402, 404 may be selectively merged in the power delivery region PDR such that they form the power delivery contacts 410-1, 410-2 thereon (see FIGS. 4A-4H below). As an example, power delivery contacts 410-1, 410-2 may be provided between or at the boundaries 402-1, 404-1 to electrically connect the power delivery tracks 450-1, 450-2 to the cell structure of the cell 402 (e.g., a PMOS cell structure) and to the cell structure of the cell 404 (e.g., a CMOS cell structure) such that a same voltage is applied to the respective cell structures of the cells 402, 404.

Additionally, some of the active patterns of the individual cells 402, 404 may be merged in the power delivery region PDR such that they form active patterns 420-1, 420-2 thereon (see FIGS. 4A-4H below). As an example, the active patterns 420-1, 420-2 are provided between or at the boundaries 402-1, 404-1. In some embodiments, the power delivery region PDR may be free of the diffusion break patterns 430. That is, the diffusion break patterns 430 are not provided in or on the power delivery region PDR and are not between or at the boundaries 402-1, 404-1.

By merging the power delivery contacts and active patterns of each of the individual cells 402, 404 in the power delivery region PDR (as depicted in circuit diagram 500 of FIG. 3B, which corresponds to the integrated circuit device 400), and by omitting the diffusion break patterns 430 in the power delivery region PDR, the integrated circuit device 400 may have a more compact layout/reduced area and/or increased density.

In some embodiments, some of the front-side signal tracks 440 may employ the reduced marginal length extension features relative to other front-side signal tracks 440. As an example, the front-side metal track 440-1, which at least partially overlaps the power delivery contacts 410-1, 410-2 in the third direction D3 may have a length in the first direction D1 that is greater than a length of front-side metal track 440-2, which is free from overlap with the power delivery contacts 410-1, 410-2 in the third direction D3 The relatively smaller length (and reduced marginal length extension) of front-side metal track 440-2 may reduce the overall area, layout complexity, and power consumption of the integrated circuit 400.

A method of forming integrated circuit device 400 is described below with reference to FIGS. 4A-4H, which illustrate schematic plan views depicting intermediate processes of forming the integrated circuit device 400. It should be understood that certain steps may not be performed in various embodiments, and the order of the steps for forming the integrated circuit device 400 are not limited to the examples illustrated and described herein.

Referring to FIGS. 4A-4B, the method may include removing a diffusion break pattern 430-1 that is on a first portion of the power delivery region PDR-1. Removing the diffusion pattern 430-1 may include, for example, performing a wet etching process and/or a dry etching process, such as plasma-enhanced etching, and using one or more mask patterns (not shown). The etching process may involve gases including, but not limited to, HBr, Cl₂, O₂, SF6, and N₂. Referring to FIG. 4C, the method may include reducing the length of front-side metal tracks 440-1, 440-2 using a cut layer as a negative mask and by performing a wet and/or dry etching process to thereby form the cell 402. The length may be reduced such that the front-side metal tracks 440-1, 440-2 are free from overlap with preliminary power delivery contacts 410-1P, 410-2P on the first portion of the power delivery region PDR-1 in the third direction D3.

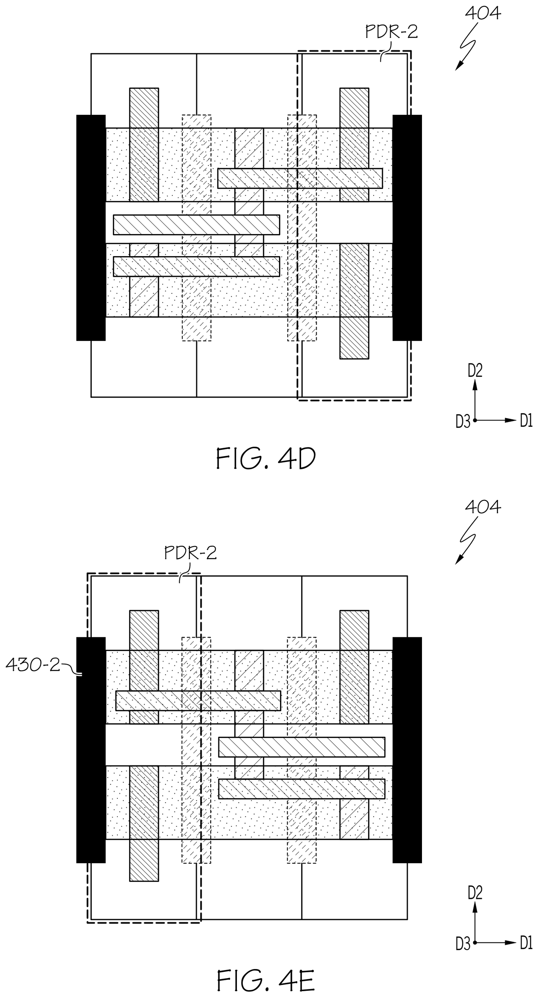

Referring to FIGS. 4D-4E, the method may include aligning a second portion of the power delivery region PDR-2 of cell 404 such that conductivities of the cell structures of the cells 402, 404 enable an electrical connection therebetween. Referring to FIGS. 4E-4F, the method may include removing a diffusion break pattern 430-2 that is on the second portion of the power delivery region PDR-2 using wet and/or dry etching processes. Referring to FIGS. 4F-4G, the method may include reducing the length of front-side metal track 440-3 using a cut layer as a negative mask and by performing a wet and/or dry etching process to thereby form the cell 404. The length may be reduced such that the front-side metal track 440-3 is free from overlap with preliminary power delivery contacts 410-3P, 410-4P on the second portion of the power delivery region PDR-2 in the third direction D3.

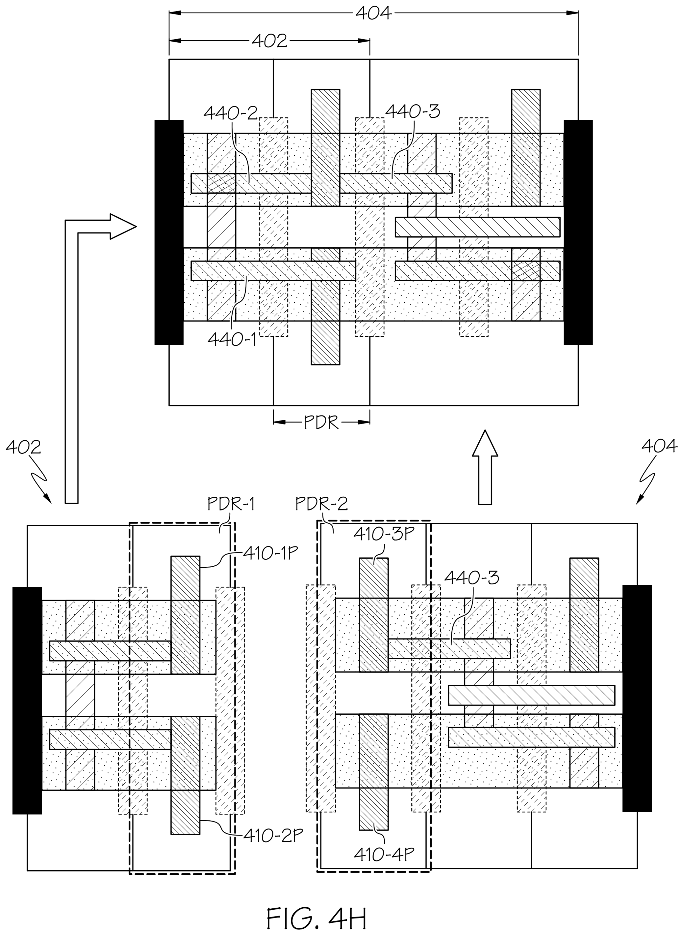

Referring to FIG. 4H, the cell 402 may be joined to the cell 404. As an example, joining the cells 402, 404 may include removing redundant preliminary power delivery contacts 410-1P and 410-2P (or preliminary power delivery contacts 410-3P, 410-4P) to form the power delivery contacts 410-1, 410-2 and to form the power delivery region PDR. Subsequently, the power delivery contacts 410-1, 410-2 may be electrically connected to the cell structures of each of the cells 402, 404 and the BSPDN (not shown).

Unless otherwise defined, all terms used herein have the same meaning as commonly understood by one of ordinary skill in the art. Further, all terms should be interpreted as having a meaning that is consistent with their meaning in the context of the relevant art and this disclosure and will not be interpreted in an idealized or overly formal sense unless expressly so defined herein.

In the description above, each example embodiment is described with reference to regions of particular conductivity types. It will be appreciated that opposite conductivity type devices may be formed by simply reversing the conductivity of the n-type and p-type layers in each of the above embodiments. Thus, it will be appreciated that the present disclosure covers both n-channel and p-channel devices for each different device structure.

The terminology used herein is for the purpose of describing particular embodiments only and is not intended to be limiting of embodiments. The singular forms "a," "an," and "the" are intended to include the plural forms as well, unless the context clearly indicates otherwise. The terms "comprises," "comprising," "includes" and/or "including" specify the presence of stated features, steps, operations, elements and/or components, but do not preclude the presence or addition of one or more other features, steps, operations, elements, components and/or groups thereof.

It will be understood that, although the terms "first," "second," etc. are used throughout this specification to describe various elements, these elements should not be limited by these terms. These terms are only used to distinguish one element from another. For example, a first element could be termed a second element, and, similarly, a second element could be termed a first element, without departing from the scope of the present disclosure. The term "and/or" includes any and all combinations of one or more of the associated listed items.

It will be understood that when an element such as a layer, region or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present. It will also be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

Spatially relative terms such as "below" or "above" or "upper" or "lower" or "top" or "bottom" may be used herein to describe a relationship of one element, layer or region to another element, layer or region based on a frame of reference (e.g., a substrate), as illustrated in the figures. It will be understood that these terms are intended to encompass different orientations of the device in addition to the orientation depicted in the figures.

Example embodiments are described herein with reference to the accompanying drawings, which may include cross-section illustrations that are schematic illustrations of idealized embodiments (and intermediate structures). Many different forms and embodiments are possible without deviating from the teachings of this disclosure. Accordingly, the disclosure should not be construed as limited to the example embodiments set forth herein. As such, it will be understood by those of ordinary skill in the art that various changes in form and details may be made therein without departing from the spirit and scope as defined herein. In the drawings, the sizes and relative sizes of layers and regions may be exaggerated for clarity. Additionally, variations from the shapes of the illustrations as a result, for example, of manufacturing techniques and/or tolerances, are to be expected.

Embodiments of the present disclosure are also described with reference to a fabrication operations and flowchart diagrams. It will be appreciated that the steps shown in the fabrication operations and flowchart diagrams need not be performed in the order shown.

## Claims

1. A circuit device comprising:
a substrate (202);
a first cell that includes a first cell structure on an upper surface of the substrate;
a second cell that includes a second cell structure on the upper surface of the substrate;
signal tracks on the upper surface of the substrate, wherein the signal tracks are electrically connected to the first cell structure and/or the second cell structure;
a first power delivery track on a lower surface of the substrate, wherein the lower surface of the substrate is opposite to the upper surface of the substrate in a first direction; and
a power delivery region that is bounded by the first cell at a first boundary and is bounded by the second cell at a second boundary, wherein the second boundary is opposite to the first boundary with respect to the power delivery region in a second direction that intersects the first direction,
wherein the power delivery region includes a first power delivery contact, and
wherein the first power delivery track is electrically connected to the first cell structure and the second cell structure through the first power delivery contact.

2. The circuit device of Claim 1, wherein the first power delivery contact is between the first boundary and the second boundary in the second direction.

3. The circuit device of Claim 1 or 2, further comprising active patterns on the substrate and diffusion break patterns that extend into the substrate,
wherein the first cell structure includes a first active pattern of the active patterns at the first boundary.

4. The circuit device of Claim 3, wherein the first cell is free of the diffusion break patterns at the first boundary.

5. The circuit device of Claim 3 or 4, wherein the first cell includes a third boundary that is opposite to the first boundary with respect to the first cell in the second direction, and
wherein the first cell structure further includes a second active pattern of the active patterns or a first diffusion break pattern of the diffusion break patterns at the third boundary.

6. The circuit device of any one of Claims 3 to 5, wherein the second cell structure includes a third active pattern of the active patterns at the second boundary.

7. The circuit device of Claim 6, wherein the second cell structure is free of the diffusion break patterns at the second boundary.

8. The circuit device of Claim 6 or 7, wherein the second cell includes a fourth boundary that is opposite to the second boundary with respect to the second cell in the second direction, and
wherein the second cell structure further includes a fourth active pattern of the active patterns or a second diffusion break pattern of the diffusion break patterns at the fourth boundary.

9. The circuit device of any one of Claims 1 to 8, wherein a first signal track of the signal tracks has a first length in the second direction, and a second signal track of the signal tracks has a second length that is less than the first length in the second direction.

10. The circuit device of Claim 9, wherein the second signal track is free of overlap with the first power delivery contact in the first direction.

11. The circuit device of Claim 10, wherein the first signal track at least partially overlaps the first power delivery contact in the first direction.

12. The circuit device of any one of Claims 1 to 11, wherein the power delivery region comprises a second power delivery contact.

13. The circuit device of Claim 12, further comprising a second power delivery track that is electrically connected to the first cell structure and the second cell structure through the second power delivery contact.

14. The circuit device of Claim 13, wherein the first power delivery track is configured to supply a first voltage, and wherein the second power delivery track is configured to supply a second voltage that is different from the first voltage.

15. The circuit device of claim 1, wherein:
the substrate includes diffusion break patterns,
the power delivery region includes at least one active pattern, and
the power delivery region is free of the diffusion break patterns.
